# EUROPEAN PATENT APPLICATION

(11) **EP 2 618 532 A1**
(43) Date of publication of application: **24.07.2013**
(21) Application number: 12151737.9
(22) Date of filing: 19.01.2012
(51) Int. Cl.: H04L 27/20

(54) **Improved Component Interleaving for Rotated Constellations**

(71) Applicant: Panasonic Corporation, Kadoma-shi Osaka 571-8501 (JP)
(72) Inventor: Petrov, Mihail, 63225 Langen (DE)
(74) Representative: Grünecker, Kinkeldey, Stockmair & Schwanhäusser

(57) **Abstract**

The present invention relates to improving the time and frequency diversity for rotated QAM constellations when used with and without time-frequency slicing, as well as to corresponding methods, transmitters, and receivers. Specifically, the present invention provides a component interleaver that ensures that components of a constellation block are mapped to different RF channels. This is achieved by writing real and imaginary components of the rotated constellations independently of each other column-by-column into a matrix with N_{R} rows, applying a cyclic shift to each column of the matrix holding the imaginary components, and reading the real and imaginary components row-by-row. The cyclic shifts are selected for each column in accordance with a shift pattern that contains only integers that are not a multiple of N_{R}. Optimum spreading of the components over time can be achieved by configuring the shift pattern such that the average shift equals N_{R}/2. The sequence of components read from the matrix may then be divided into slices, each of which may then be transmitted through a corresponding RF channel. The present invention also provides a component interleaver for D-dimensional rotated constellations that provides an even spreading of the components of each constellation over the FEC block by setting N_{R}=D and shifting each column of the matrix holding the imaginary components by D/2 components.

## Description

### FIELD OF THE INVENTION

The present invention relates to digital communications and more specifically to improving the time and frequency diversity for rotated QAM constellations when used with and without time-frequency slicing, as well as to corresponding methods, transmitters, and receivers.

### BACKGROUND OF THE INVENTION

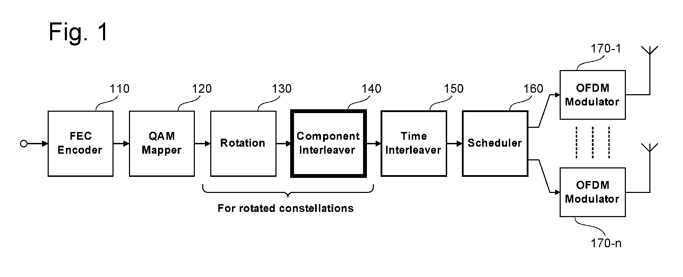

Figure 1 shows the block diagram of a transmitter-side communication chain that employs rotated quadrature amplitude modulation (QAM) constellations and time-frequency slicing (TFS). The transmitter receives at its input binary blocks of a predetermined length, which contain the information to be transmitted.

Each information block is first encoded by a forward-error-correction (FEC) encoder 110. The encoding process adds redundancy in order to make the reception of the information block more robust against errors. Two notable examples of FEC code families are low-density parity-check (LDPC) codes and turbo codes.

The bits of the encoded FEC codeword, thereafter referred to as FEC block, are mapped onto real-valued pulse amplitude modulation (PAM) symbols, each taking a value from a discrete set of 2^{B} values, where B is the number of bits encoded in a PAM symbol. The mapping can be straightforward or through a bit interleaver (not shown). How the B bits are mapped to PAM symbols is well understood and not directly relevant to the present invention. The relevant aspect is that each FEC block is transformed into a block of PAM symbols.

The PAM symbols are typically grouped in pairs to form complex quadrature amplitude modulation (QAM) symbols, which are also referred to as cells. These cells can be optionally permuted using a cell interleaver. The mapping of bits of the encoded FEC codeword onto QAM symbols is performed by QAM mapper 120.

The interleaved PAM symbols are then demultiplexed into vectors of D symbols. These vectors can be regarded as identifying unique points in a D-dimensional space, the resulting 2^{BD} combinations forming a multi-dimensional constellation. Each vector is multiplied by an orthogonal DxD matrix, which can be regarded as a generalized rotation in the D-dimensional space, hence the term rotated constellations. This operation is performed by rotation block 130 in Fig. 1. The particular structure of the rotation matrix is not relevant to the present invention. Specific examples for suitable rotation matrices can be found in co-pending application EP 2 288 048 A, which is incorporated herewith in its entirety.

Rotated constellations are an effective tool for improving the robustness of communication systems under channels with heavy fading and erasures. Preferably, D is a power of 2 (usually 2, 4 or 8). Preferably, the number of PAM symbols per FEC block is a multiple of D. In the following, the rotated vectors of D real symbols will be referred to as constellation blocks (CB) and the real symbols as components or dimensions.

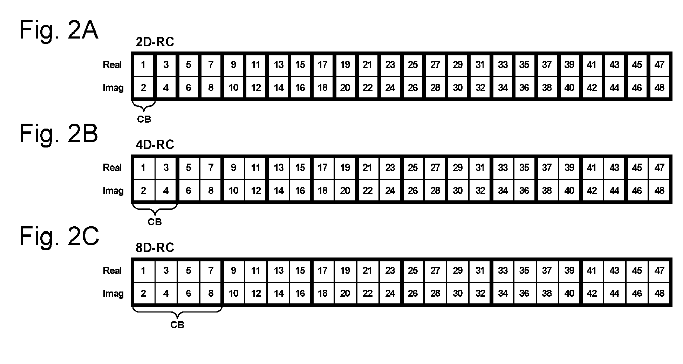

A typical example of grouping real PAM symbols into complex QAM symbols, followed by their rotation in D dimensions, is shown in Figures 2A-C for 2D, 4D, and 8D rotated constellations, respectively, for a FEC block consisting of 48 PAM symbols. In these examples each constellation block comprises D/2 adjacent QAM symbols (cells). This assumption will be used throughout this specification.

In order for the constellation rotation to be effective in enhancing the robustness of the system, the fading experienced by the D components of each constellation block must be as uncorrelated as possible, which is achieved by spreading the D components as evenly as possible over time and frequency. Typically, this is performed by first spreading the D components over the FEC block so that the D components of each constellation block are mapped to different complex cells, then by spreading the cells of each FEC block evenly over time and the available RF channels.

The former step is used only for rotated constellations and is performed by the component interleaver, while the latter step is used for both rotated and non-rotated constellations and is performed by the time interleaver in conjunction with the scheduler. This will be explained in greater detail herebelow.

In order to achieve an even spreading the D rotated-constellation components over time and the available RF channels, the two steps must be correlated. Since the time interleaver 150 and the scheduler 160 are used also for non-rotated constellations, it follows that the spreading performed by the RC component interleaver 140 must be adapted according to the functionality of the former two blocks.

In order to increase the time diversity of the system, the cells of each FEC block are spread in time, typically through interleaving with cells from other FEC blocks. This function is performed by the time interleaver 150, which can be a block interleaver, a convolutional interleaver, or a combination of both. In the DVB-T2 standard (Digital Video Broadcasting - Second Generation Terrestrial) for example, the time interleaver is a block interleaver. Further details on the DVB-T2 standard can be found in standardization document ETSI EN 302.755, which is incorporated herewith in its entirety.

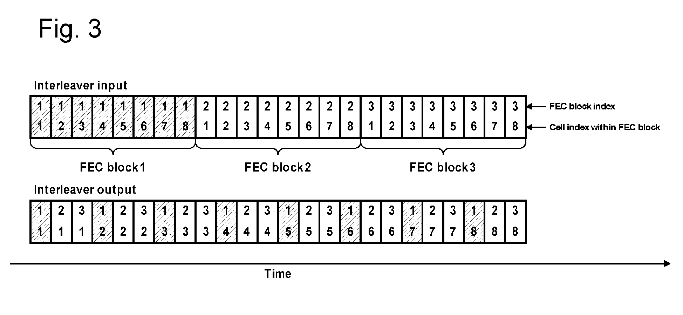

Figure 3 shows an example of a straightforward time interleaving scheme for three FEC blocks, each block consisting of eight complex cells. The cells of the first FEC block are highlighted to improve clarity. As can be seen from Fig. 3, the time interleaver increases the time interval over which the cells of a FEC block are transmitted, thus increasing the time diversity. This time interval is also referred to as interleaving duration.

The allocation of the time-interleaved cells to the available transmit resources is performed by the scheduler 160 in Fig. 1. The transmit resources can be samples, in the case of single-carrier modulation, or multi-carrier symbols, in the case of multi-carrier modulation such as orthogonal frequency-division multiplexing (OFDM). In OFDM the symbols themselves consist of a plurality of complex cells. In any case the mapping is assumed to be monotonic, i.e., the ordering of the cells in time is not changed. The scheduling (allocation) of the cells is typically signaled to the receiver through dedicated signaling information. When time-frequency slicing (TFS) is used, the scheduler also allocates the cells to the available RF channels in a TFS group. This will be explained in greater detail herebelow.

For each RF channel the scheduler output is further processed by a chain comprising at least a modulator (170-1,..., 170-n), an up-converter (not shown) from digital baseband to analog RF, and an RF power amplifier (not shown). The modulator uses e.g. orthogonal frequency-division multiplexing (OFDM) modulation and may include frequency interleaving for increased frequency diversity.

Regarding the temporal separation of the constellation components, the best performance with rotated constellations is obtained when the D components are evenly spread over the entire time-interleaving duration. Depending on the concrete scheduling and slicing of the FEC block, meeting this condition exactly may not always be possible. The best solution, which works reasonably well in most cases, is to spread the D constellation components evenly over the FEC block. The complex cells of the FEC block are then transmitted over the time-interleaver period, and in the stated order.

One approach for increasing the reliability of a communication system is to exploit the diversity available over a plurality of RF channels, hereafter referred to as channel diversity. The main type of diversity is the frequency diversity, which results from the fact that fading in wireless channels tends to be frequency selective and thus the fading correlation between any two RF channels is relatively low.

Moreover, if the transmitters for the different RF channels are located in different geographical locations, also the so-called spatial diversity is exploited. The channel diversity results therefore from both the frequency and the spatial diversity.

In order to enable the reception with a single tuner in the receiver, the information to be received continuously, e.g. a broadcast program, must not be sent over more than one RF channel at any given time. It is therefore necessary to use a time-frequency slicing scheduling, so that the receiver can hop from one frequency to the other and extract the desired data from each RF channel during the appropriate slice. The scheduling (time-frequency allocation) of the slices is typically signaled to the receiver through dedicated signaling information.

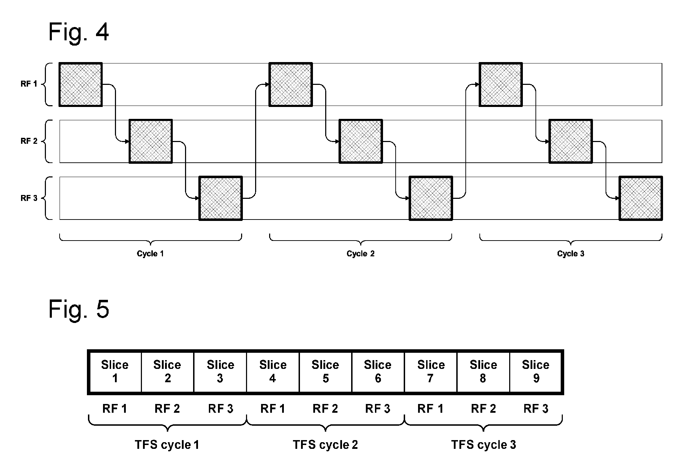

Figure 4 shows an example of TFS slicing and scheduling for three RF channels and three TFS hopping cycles. In order to allow the tuner to hop between two RF channels, a guard interval is required between two consecutive slices.

In the following, the number of RF channels in a TFS group is denoted by N_{RF} and the number of TFS cycles over which a FEC block is spread by N_{C}. The number of slices over which a FEC block is spread is therefore N_{S}=N_{RF}*_{NC}. An optimal diversity is achieved when all slices have the same length and each FEC block has the same number of cells in all slices. Figure 5 shows how a FEC block is sliced for TFS with three RF channels and three cycles, corresponding to the TFS scheduling example in Figure 4. The slicing process is straightforward.

When rotated constellations are used, the D components must be mapped evenly onto the RF channels. For example, for 2D rotated constellations the two components must be mapped onto all possible pairs of RF channels. For 3 RF channels these pairs are: (1 &2), (1 &3), (2&3). Mapping the two components onto the same RF channel must be avoided.

To summarize, the component interleaver must ensure that the constellation components are 1) spread as evenly as possible over the time-interleaving duration, and 2) mapped to all possible combinations of RF channels for the TFS cases. If it's not possible to meet both conditions, it is preferable to guarantee the latter at the expense of the former.

A conventional solution for component interleaving is known from document TM-NGH1172 published internally by the DVB organization. This document is authored by Marco Breiling from the Fraunhofer Institute for Integrated Circuits (IIS) in Erlangen, Germany, and is entitled "Details of the Cell + Time Interleaving".

The conventional component interleaver works on FEC blocks and applies a different permutation to the real and the imaginary components of the complex cells of the FEC block. The interleaver is optimized for 2D-RC, where the two constellation components are initially the real and the imaginary components of a complex cell, respectively, as in Fig. 2A.

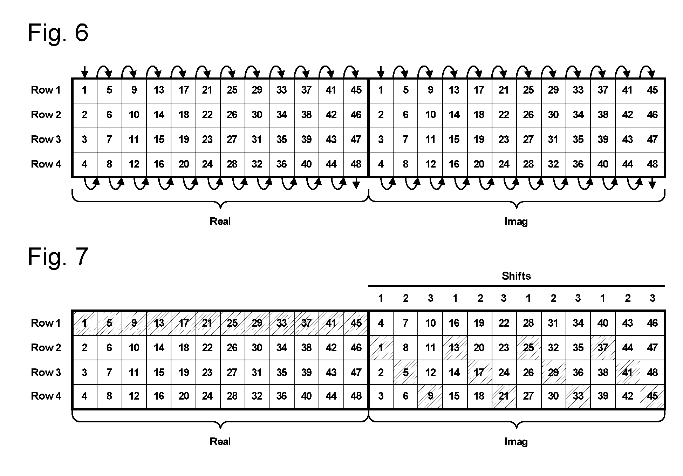

Operation of the conventional component interleaver will now be described in connection with Figs. 6-9.

Fig. 6 illustrates a first step, in which the cells of each FEC block are written column by column into matrix with N_{R} rows, where N_{R} is a parameter of the interleaver. This is equivalent with writing the real and the imaginary components synchronously into two identical matrices, as shown in Fig. 6 for N_{R}=4 and 48 cells per FEC block.

In a second step, cyclic shifts are applied to the columns of the imaginary-component matrix in order to introduce a separation between the real and the imaginary components of each cell. The shifts are not the same for all columns. Instead, the shift pattern is (1, 2, ..., N_{R}-1) for the first N_{R}-1 columns, and repeated for the remaining columns, as indicated in Fig. 7. In other words, the amount of shift that is applied to a given column is determined by a corresponding entry of the shift pattern which is a sorted set of integers (a tuple). The "corresponding" entry means the first entry for the first column, the second entry for the second column, and so on, with the shift pattern being periodically continued. Instead of periodically continuing the shift pattern, the entry may also be cyclically selected from the shift pattern, i.e. selected modulo the length of the shift pattern.

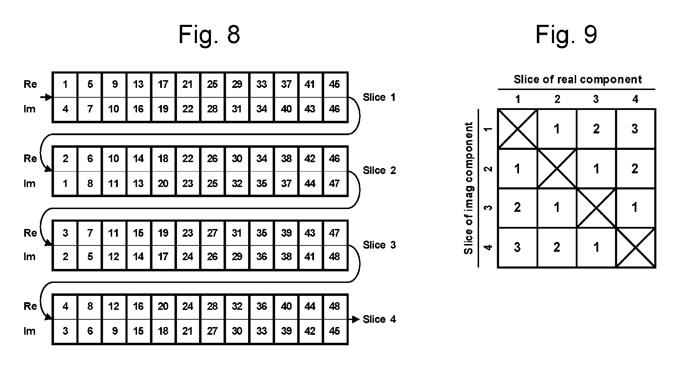

In a third step, the two matrices are read out row by row and complex cells are formed from their elements. The result is a FEC block divided into N_{R} slices of equal size, the two components of each 2D constellation being mapped to two different slices, as shown in Figure 8. The distance between the two components is therefore at least 1/N_{R} of the number of cells in a FEC block.

All combinations of two different slices are possible and occur with the same frequency, as shown in Figure 9 for N_{R}=4. This figure shows in each square the distance in slices between the two constellation components.

More exactly, the distance in slices between the two components of a 2D rotated constellation belongs to the following discrete set: 1, 2, ... , N_{R}-1. Unlike the slice pairs, not all distances occur with the same frequency. Larger distances occur less frequently than smaller distances, and the resulting histogram resembles a triangle.

The prior-art component interleaver is ideal for TFS when the number of rows N_{R} is chosen to be equal to the number of RF channels N_{RF}. For 2D constellations, the components are mapped onto all possible RF channel pairs. For example, in the case of TFS with 4 RF channels these pairs are: (1 &2), (1 &3), (1 &4), (2&3), (2&4), (3&4).

When a FEC block is interleaved over multiple TFS cycles, the number of rows N_{R} is chosen to be equal with the number of TFS slices per FEC block N_{S}=N_{RF}*N_{C}, where N_{C} is the number of TFS cycles. The periodic shift pattern will still be (1, 2, ..., N_{R}-1).

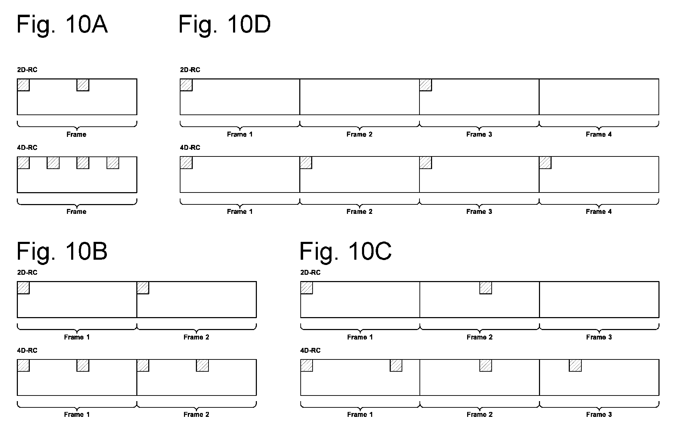

The conventional component interleaver has a problem when a FEC block is interleaved over multiple TFS cycles in that some constellation components get mapped onto the same RF channel. More specifically, this happens for all components in columns whose cyclic shift is a multiple of N_{RF}. This problem is illustrated in Fig. 10 for three RF channels and two TFS cycles. Therefore, the performance of the conventional component interleaver is suboptimal.

### SUMMARY OF THE INVENTION

It is the object of the present invention to overcome the above problem in the prior art. Specifically, it is an object of the present invention to provide a component interleaver that produces an optimal temporal separation of the constellation components, as well as an optimal mapping of the constellation components to the RF channels for time-frequency slicing.

This is achieved by the features as set forth in the independent claims. Preferred embodiments are the subject matter of dependent claims.

It is the particular approach of the present invention to configure the shift pattern of the conventional component interleaver such that shifts that are a multiple of N_{RF} are skipped.

According to a first aspect of the present invention, a method for transmitting digital data over a plurality of N_{RF} frequency channels is provided. The method comprises the steps of encoding a block of data with a forward error correction code; mapping the encoded block of data to a sequence of complex symbols; writing the real components of the sequence of complex symbols column-by-column into a first matrix having N_{R} rows and writing the imaginary components of the sequence of complex symbols column-by-column into a second matrix having N_{R} rows; applying a cyclic shift to each column of the second matrix such that the imaginary components of the column are rotated by a certain number, the certain number being cyclically selected for each column from a shift pattern comprising a set of integers greater than zero and less than N_{R}; obtaining a sequence of shuffled complex symbols by reading the real components of the shuffled complex symbols from the first matrix row-by-row and the imaginary components of the shuffled complex symbols from the cyclically shifted second matrix row-by-row; dividing the sequence of shuffled complex symbols into a plurality of slices, each slice being mapped to one of the N_{RF} frequency channels; and transmitting the complex symbols of each slice over the corresponding frequency channel, and is characterized in that N_{R} is a multiple of N_{RF} greater than N_{RF}; and the shift pattern contains only integers that are not a multiple of N_{RF}.

According to a second aspect of the present invention, a method for receiving digital data over a plurality of N_{RF} frequency channels is provided. The method comprises the steps of receiving complex symbols of each slice of a plurality of slices over a corresponding one of the N_{RF} frequency channels; obtaining a sequence of complex symbols by joining the received complex symbols; writing the real components of the sequence of complex symbols row-by-row into a first matrix having N_{R} rows and writing the imaginary components of the sequence of complex symbols row-by-row into a second matrix having N_{R} rows; applying a cyclic shift to each column of the second matrix such that the imaginary components of the column are rotated by a certain number, the certain number being cyclically selected for each column from a shift pattern comprising a set of integers greater than zero and less than N_{R}; obtaining a sequence of de-shuffled complex symbols by reading the real components of the shuffled complex symbols from the first matrix column-by-column and the imaginary components of the shuffled complex symbols from the cyclically shifted second matrix column-by-column; demodulating an encoded block of data from the sequence of complex symbols; and subjecting the encoded block of data to forward error correction decoding, and is characterized in that N_{R} is a multiple of N_{RF} greater than N_{RF}; and the shift pattern contains only integers that are not a multiple of N_{RF}.

According to a third aspect of the present invention, a transmitter for transmitting digital data over a plurality of N_{RF} frequency channels is provided. The transmitter comprises an encoder (110) for encoding a block of data with a forward error correction code; a symbol mapper (120) for mapping the encoded block of data to a sequence of complex symbols; a component interleaver adapted for writing the real components of the sequence of complex symbols column-by-column into a first matrix having N_{R} rows, for writing the imaginary components of the sequence of complex symbols column-by-column into a second matrix having N_{R} rows, for applying a cyclic shift to each column of the second matrix such that the imaginary components of the column are rotated by a certain number, the certain number being cyclically selected for each column from a shift pattern comprising a set of integers greater than zero and less than N_{R}, and for obtaining a sequence of shuffled complex symbols by reading the real components of the shuffled complex symbols from the first matrix row-by-row and the imaginary components of the shuffled complex symbols from the cyclically shifted second matrix row-by-row; a scheduler (160) dividing the sequence of shuffled complex symbols into a plurality of slices, each slice being mapped to one of the N_{RF} frequency channels; and a plurality of modulators (170-1, ..., 170-n) transmitting the complex symbols of each slice over the corresponding frequency channel, and is characterized in that N_{R} is a multiple of N_{RF} greater than N_{RF}; and the shift pattern contains only integers that are not a multiple of N_{RF}.According to a fourth aspect of the present invention, a receiver for receiving digital data over a plurality of NR_{F} frequency channels is provided. The receiver comprises a demodulator (270) for receiving complex symbols of each slice of a plurality of slices over a corresponding one of the N_{RF} frequency channels; a cell extractor (255) for obtaining a sequence of complex symbols by joining the received complex symbols; a component de-interleaver (240) adapted for writing the real components of the sequence of complex symbols row-by-row into a first matrix having N_{R} rows, for writing the imaginary components of the sequence of complex symbols row-by-row into a second matrix having N_{R} rows, for applying a cyclic shift to each column of the second matrix such that the imaginary components of the column are rotated by a certain number, the certain number being cyclically selected for each column from a shift pattern comprising a set of integers greater than zero and less than N_{R}, and for obtaining a sequence of de-shuffled complex symbols by reading the real components of the shuffled complex symbols from the first matrix column-by-column and the imaginary components of the shuffled complex symbols from the cyclically shifted second matrix column-by-column; a constellation demapper (220) for demapping an encoded block of data from the sequence of complex symbols; and a decoder (210) for subjecting the encoded block of data to forward error correction decoding, and is characterized in that N_{R} is a multiple of N_{RF} greater than N_{RF}; and the shift pattern contains only integers that are not a multiple of N_{RF}.

Preferably, the encoded block of data is mapped to a sequence of real-valued symbols, which is divided into a plurality of D-dimensional vectors. Each of the D-dimensional vectors is transformed by multiplying the vector with an orthogonal matrix, resulting in a plurality of constellation blocks, each constellation block consisting of D real-valued transformed symbols. The real-valued transformed symbols of the plurality of constellation blocks are then mapped to the sequence of complex symbols. In this manner rotated constellations may be employed in order to further improve the error resilience of the communication channel.

In a preferred embodiment, the shift pattern is configured such that for each first integer greater than zero and less than N_{RF} there is a second integer in the shift pattern such that a remainder of dividing the second integer by NR_{F} equals the first integer. In this manner, all shifts (modulo N_{RF}) between 1 and N_{RF}-1 are covered by the shift pattern in order to obtain an optimum spreading of the components over the various RF channels.

In a particularly preferred embodiment, the length of the shift pattern equals N_{RF}-1. With such a shift pattern only the minimum number of elements in the shift pattern is employed so as to improve the temporal separation of the components.

In another particularly preferred embodiment, the shift pattern is configured such that an arithmetic average of its integers equals N_{R}/2. With such a shift pattern, an optimum separation of the components may be achieved.

According to a further aspect of the present invention, a method and a corresponding apparatus for transmitting digital data is provided. The method comprises the steps of encoding a block of data with a forward error correction code; mapping the encoded block of data to a sequence of real-valued symbols, the sequence of real-valued symbols being divided into a plurality of D-dimensional vectors; transforming each of the D-dimensional vectors by multiplying the vector with an orthogonal matrix, resulting in a plurality of constellation blocks, each constellation block consisting of D real-valued transformed symbols; mapping the real-valued transformed symbols of the plurality of constellation blocks to a sequence of complex symbols; writing the real components of the sequence of complex symbols column-by-column into a first matrix having N_{R} rows and writing the imaginary components of the sequence of complex symbols column-by-column into a second matrix having N_{R} rows; applying a cyclic shift to each column of the second matrix; obtaining a sequence of shuffled complex symbols by reading the real components of the shuffled complex symbols from the first matrix row-by-row and the imaginary components of the shuffled complex symbols from the cyclically shifted second matrix row-by-row; and transmitting the shuffled complex symbols, and is characterized in that the number of rows N_{R} of the first and the second matrix equals D, and the cyclic shift is performed such that the imaginary components of each column are rotated by D/2 components.

According to a further aspect of the present invention, a method and a correpsonding apparatus for receiving digital data is provided. The method comprises the steps of receiving a sequence of complex symbols; writing the real components of the sequence of complex symbols row-by-row into a first matrix having N_{R} rows and writing the imaginary components of the sequence of complex symbols row-by-row into a second matrix having N_{R} rows; applying a cyclic shift to each column of the second matrix; obtaining a sequence of de-shuffled complex symbols by reading the real components of the shuffled complex symbols from the first matrix column-by-column and the imaginary components of the shuffled complex symbols from the cyclically shifted second matrix column-by-column; demapping (255, 230) a plurality of constellation blocks from the sequence of complex symbols, each constellation block consisting of D real-valued transformed symbols; demodulating an encoded block of data from the plurality of constellation blocks; and subjecting the encoded block of data to forward error correction decoding, and is characterized in that the number of rows N_{R} of the first and the second matrix equals D, and the cyclic shift is performed such that the imaginary components of each column are rotated by D/2 components.

The above and other objects and features of the present invention will become more apparent from the following description and preferred embodiments given in conjunction with the accompanying drawings, in which:
- Fig. 1: shows an exemplary block diagram of a transmitter-side communication chain;
- Figs. 2A-C: illustrate examples of applying constellation rotation to a FEC block consisting of 48 real PAM symbols with 2D-RC, 4D-RC, and 8D-RC, respectively;
- Fig. 3: illustrates an example of time interleaving;
- Fig. 4: is a schematic diagram illustrating time-frequency slicing with three RF channels;
- Fig. 5: is a schematic diagram illustrating the result of slicing a FEC block for TFS with three RF channels and three cycles;
- Fig. 6: is a schematic diagram illustrating the result of writing the real and imaginary components of a FEC block into 4-row matrices;
- Fig. 7: is a schematic diagram illustrating the result of applying cyclic shifts to the columns of the imaginary-part matrix;
- Fig. 8: is a schematic diagram illustrating the output of a conventional component interleaver;
- Fig. 9: illustrates all possible distances between the two 2D-RC components for an interleaver with four rows;
- Fig. 10A: is a schematic diagram illustrating the spreading of a FEC block over one frames for 2D-RC and 4D-RC;
- Fig. 10B: is a schematic diagram illustrating the spreading of a FEC block over two frames for 2D-RC and 4D-RC;
- Fig. 10C: is a schematic diagram illustrating the spreading of a FEC block over three frames for 2D-RC and 4D-RC;
- Fig. 10D: is a schematic diagram illustrating the spreading of a FEC block over four frames for 2D-RC and 4D-RC;
- Fig. 11: is a schematic diagram illustrating the result of applying a component interleaver according to an embodiment of the present invention to an FEC block having 24 complex cells in a configuration with 2-dimensional rotated constellations;
- Fig. 12: is a schematic diagram illustrating the result of applying a component interleaver according to an embodiment of the present invention to an FEC block having 24 complex cells in a configuration with 4-dimensional rotated constellations;
- Fig. 13: is a schematic diagram illustrating the result of applying the conventional component interleaver to three RF channels and two TFS cycles;
- Fig. 14: is a schematic diagram illustrating the result of applying a component interleaver according to an embodiment of the present invention to three RF channels and two TFS cycles;
- Fig. 15: is a schematic diagram illustrating the result of applying a component interleaver according to a further embodiment of the present invention to three RF channels and two TFS cycles, employing only N_{RF}-1 shifts;
- Fig. 16: is a schematic diagram illustrating the result of applying a component interleaver according to a further embodiment of the present invention to four RF channels and two TFS cycles, employing an extended shift pattern; and
- Fig. 17: shows an exemplary block diagram of a TFS receiver.

### DETAILED DESCRIPTION

The inventor has realized that having all shifts in the shift pattern, i.e. (1, 2, ..., N_{R}-1), as in the prior art, leads to a sub-optimal interleaving of the constellation components in some configurations. Two such notable configurations are: 1) the non-TFS case, and 2) TFS with multiple cycles per time-interleaving period. According to a first aspect of the invention, better interleaving can be achieved by reducing the possible shifts in the shift pattern. The number of distinct shifts will be less than N_{R}-1.

For the non-TFS case, the D constellation components are to be spread evenly over the FEC block, as mentioned before.

In frame-based communication systems, when a FEC block is spread over several frames (N_{F}>1), the D dimensions of each constellation block must be distributed as evenly as possible among the N_{F} frames. If D is larger than N_{F} some frames will carry more than one component from some constellation blocks. In that case, these components must be spread over the frame as evenly as possible.

In Figs. 10A to 10D, several examples are provided in order to illustrate these points. These examples illustrate the mapping of the D real components (shown as squares) of a constellation block. Specifically, Figs. 10A, 10B, 10C, and 10D show the ideal mapping in case of a FEC block being spread over one, two, three, and four frames, respectively, both for 2D rotated constellations (2D-RC) and 4D rotated constellations (4D-RC).

In the case of a 2D-RC spread over four frames, it can be easily seen that mapping component pairs on frames 1&3 and 2&4 is the best solution since it ensures that the time interval between the two components of any constellation is 2 frames. Mapping on frames 1&2 and 3&4 also results in an even distribution but the time interval is only 1 frame. Mapping on frames 1&4 and 2&3 is not good because the time interval is 2 on average but it is not the same for all constellation blocks, being either 1 or 3 frames.

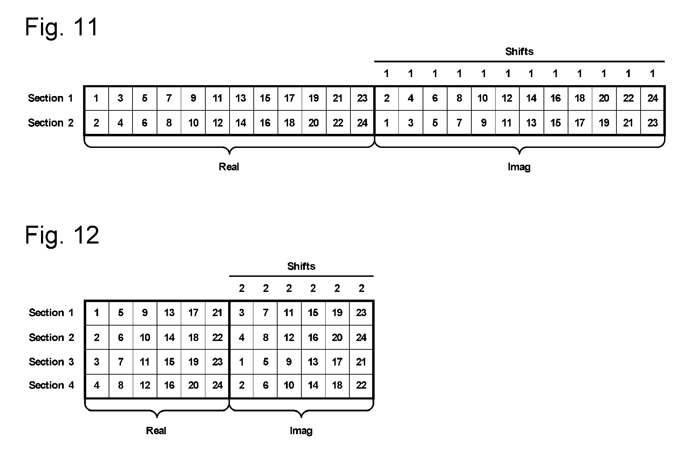

According to an aspect of the invention, spreading the D constellation components evenly over the FEC block is achieved by 1) choosing the number of rows in the two interleaver matrices N_{R} to be exactly D, and 2) applying a shift of D/2 to all the columns of the matrix of the imaginary components. Fig.11 and Fig. 12 show the interleaver matrices for rotated constellations in 2 and 4 dimensions, respectively, for an exemplar FEC block having 24 complex cells. The output FEC block consist of D contiguous sections of equal size. Each constellation block has one component in each section, and the D components of each constellation block are evenly spread over the FEC block. (This assumes that initially each constellation block is mapped to D/2 complex cells, as in Figure 2)

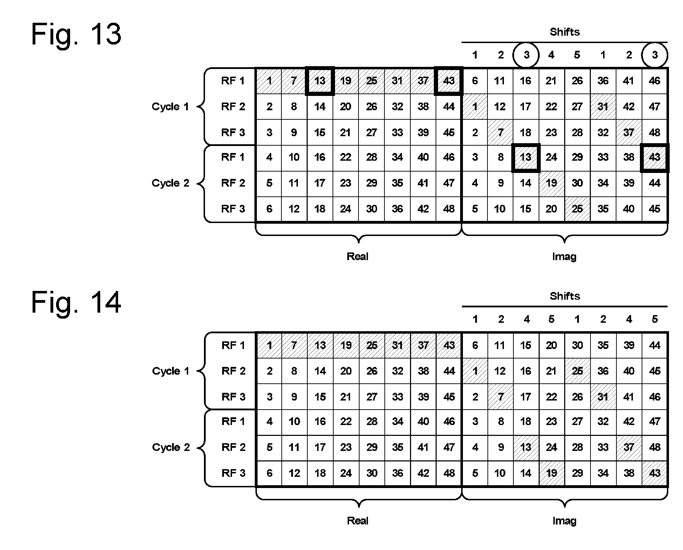

For the TFS case with multiple TFS cycles per time-interleaver period, the component mappgin produced by the conventional component interleaver is also suboptimal. As illustrated in Fig. 13 for three RF channels and two TFS cycles, all components in columns whose cyclic shift is a multiple of N_{RF} will be mapped to the same RF channel.

Therefore, according to a first aspect of the invention, those shifts that are multiples of N_{RF} are removed from the conventional shift pattern. In other words, cyclic shifts that are multiples of N_{RF} are skipped.

Referring again to the example of Fig. 13, which illustrates the result of applying the conventional component interleaver to three RF channels and two TFS cycles by means of shift pattern (1, 2, 3, 4, 5), the conventional shift pattern is modified to become (1, 2, 4, 5), i.e., to delete cyclic shifts that are multiples of N_{RF} =3.

As it is apparent from Fig. 14, which illustrates the result of applying a component interleaver according to an embodiment of the present invention to three RF channels and two TFS cycles, mapping of the constellation components onto the RF channels is now optimal in the sense that the real component and the imaginary component of each constellation are mapped to two different RF channels.

However, the temporal separation between the constellation components can still be improved. Since the cells of a FEC block are transmitted monotonically in time, the temporal separation is maximized when the distance between the constellation components is maximized within a FEC block. For 2D rotated constellations, this means that the distance between the two components of each constellation block must be half the number of cells in a FEC block.

In the case of only one TFS cycle, the conventional component interleaver cannot be modified to improve the temporal separation, since that would impair the optimum mapping of the constellation components onto the RF channels, which is more important than a maximal temporal separation.

In the case of multiple TFS cycles, the inventor has realized that the temporal separation can be improved without affecting the optimality of the component mapping to the RF channels.

According to a further aspect of the present invention, the temporal separation can be improved by reducing the number of elements in the shift pattern applied to the columns of the prior-art component interleaver, while still ensuring an optimum RF-channel mapping. The latter can be guaranteed by keeping only N_{RF}-1 shifts from the original shift pattern of length N_{C}*(N_{RF}-1), such that their values modulo N_{RF} are all the integers from 1 to N_{RF}-1, not necessary in ascending order.

Referring specifically to the example shown in Fig. 14 with N_{RF}=3, where the shift pattern contains the shifts (1, 2, 4, 5), only two shifts need to be kept. Examples of shortened shift patterns that ensure the optimality of the RF-channel mapping are: (1, 2), (2, 4), and (4, 5). Note that the corresponding values modulo N_{RF} are (1, 2), (2, 1), and (1, 2), respectively.

In order to ensure a component separation that is as close as possible to the ideal value of half a FEC block, the N_{RF}-1 shifts that are kept from the original pattern may be carefully selected. For instance, the selected shifts may form a contiguous block in the original pattern with an arithmetic mean that is preferably as close as possible to N_{R}/2, where N_{R} is the number of rows in the interleaver matrix. Note that N_{R}/2 is fractional if N_{R} is odd. In other words, the selected shifts are concentrated around an average shift of N_{R}/2, i.e., have the least possible standard deviation.

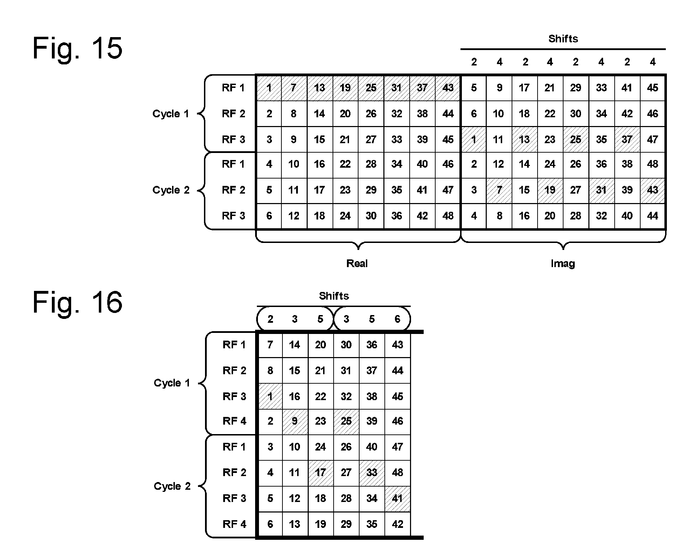

For the example in Fig. 14, where N_{R}=6, the only shift pattern that fulfills this condition is (2, 4), as illustrated in Fig. 15. The average shift is 3, which is exactly N_{R}/2.

If there is no shortened shift pattern with an average shift of exactly N_{R}/2, the shift pattern with the nearest lower or higher average shift can be selected. This happens when the number of RF channels and the number of TFS cycles are both even.

Since the average shift is not exactly N_{R}/2, also the average component separation will not be exactly half a FEC block. If needed, the average component separation can be made exactly half a FEC block by making the average column shift exactly N_{R}/2.

According to a further aspect of the invention, this can be achieved by appending to the shortened shift pattern the result of subtracting the shortened shift pattern from N_{R}. Cyclically shifting by N_{R}-k is equivalent to shifting in the opposite direction by k. An example is shown in Fig. 16 for four RF channels and two TFS cycles, where only the first 48 imaginary components are shown. The full-length shift pattern is (1, 2, 3, 5, 6, 7) and N_{R}/2=4. The shortened pattern with the nearest lower average shift is (2, 3, 5), which has an average shift of 3.666. The reflected version with the elements in ascending order is (3, 5, 6), which has an average shift of 4.333. The combined shift pattern is (2, 3, 5, 3, 5, 6), which has an average shift of 4, i.e. exactly N_{R}/2.

The order of the shifts within a shift pattern is not important, so the above combined pattern can also be expressed as (2, 3, 3, 5, 5, 6). This is true for all shift patterns discussed in this specification.

For the sake of clarity, Tables 1 to 4 show the full-length and the shortened shift patterns for TFS with 2, 3, 4, and 5 RF channels, respectively. In each case, 2 to 5 TFS cycles are considered. The cases where the shortened shift pattern is of double length, i.e. 2*(N_{RF}-1), are marked by a star.

**Table 1. Shift patterns for 2 RF channels**

| | | Full pattern | Shortened pattern |
|---|---|---|---|
| TFS cycles | 2 | (1, 3) | (1, 3) * |
| | 3 | (1,3,5) | (3) |
| | 4 | (1,3,5,7) | (3,5)* |
| | 5 | (1,3,5,7,9) | (5) |

**Table 2. Shift patterns for 3 RF channels**

| | | Full pattern | Shortened pattern |
|---|---|---|---|
| TFS cycles | 2 | (1, 2, 4, 5) | (2, 4) |
| | 3 | (1, 2, 4, 5, 7, 8) | (4, 5) |
| | 4 | (1, 2, 4, 5, 7, 8, 10, 11) | (5,7) |
| | 5 | (1, 2, 4, 5, 7, 8, 10, 11, 13, 14) | (7,8) |

**Table 3. Shift patterns for 4 RF channels**

| | | Full pattern | Shortened pattern |
|---|---|---|---|
| TFS cycles | 2 | (1, 2, 3, 5, 6, 7) | (2, 3, 5, 3, 5, 7) * |
| | 3 | (1, 2, 3, 5, 6, 7, 9, 10, 11) | (5, 6, 7) |
| | 4 | (1, 2, 3, 5, 6, 7, 9, 10, 11, 13, 14, 15) | (6, 7, 9, 7, 9, 10) * |
| | 5 | (1, 2, 3, 5, 6, 7, 9, 10, 11, 13, 14, 15, 17, 18, 19) | (9, 10, 11) |

**Table 4. Shift patterns for 5 RF channels**

| | | Full pattern | Shortened pattern |
|---|---|---|---|
| TFS cycles | 2 | (1, 2, 3, 4, 6, 7, 8, 9) | (3, 4, 6, 7) |
| | 3 | (1, 2, 3, 4, 6, 7, 8, 9, 11, 12, 13, 14) | (6, 7, 8, 9) |
| | 4 | (1, 2, 3, 4, 6, 7, 8, 9, 11, 12, 13, 14, 16, 17, 18, 19) | (8, 9, 11, 12) |
| | 5 | (1, 2, 3, 4, 6, 7, 8, 9, 11, 12, 13, 14, 16, 17, 18, 19, 21, 22, 23, 24) | (11, 12, 13, 14) |

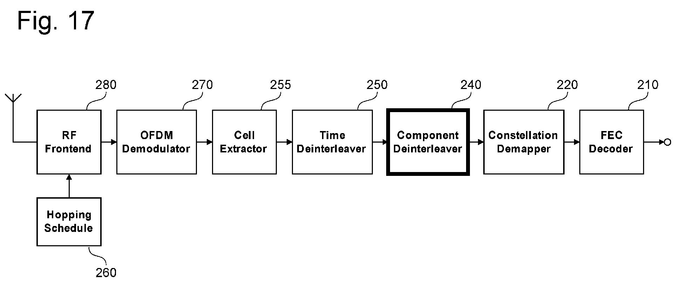

Fig. 17 shows a block diagram of a TFS receiver in accordance with embodiments of the present invention. The receiver functionality mirrors the functionality of the transmitter shown in Fig. 1. The received signal is first processed by a radiofrequency RF frontend (280), which typically comprises a tuner and a down-converter to digital baseband (not shown). The RF frontend hops between RF channels, according to the TFS scheduling information 260 signaled by the transmitter. For the non-TFS case, the RF frontend (280) always receives the same RF channel and there is no hopping schedule.

The digital baseband signal is then demodulated by the demodulator 270, resulting in a stream of complex cells and their associated complex channel coefficients. The cells belonging to the desired services are extracted by the cell extractor 255 from the demodulated cell stream according to the allocation information signaled by the transmitter.

The extracted cells are then deinterleaved by the time deinterleaver 250, which groups the extracted cells into FEC blocks, each FEC block comprising a predetermined number of cells. For each FEC block, the component deinterleaver 240 applies to the real and the imaginary components the inverses of the two component permutations disclosed above.

From the component-deinterleaved FEC blocks, groups of D real components (corresponding to the D dimensions of a rotated constellation block) are extracted and demodulated by the constellation demapper 220, which produces B*D bits per constellation block at its output. These bits are then decoded by the FEC decoder 210 and fed to the subsequent blocks for further processing.

Summarizing, the present invention relates to improving the time and frequency diversity for rotated QAM constellations when used with time-frequency slicing, as well as to corresponding methods, transmitters, and receivers. Specifically, the present invention provides a component interleaver that ensures that components of a constellation block are mapped to different RF channels. This is achieved by writing real and imaginary components of the rotated constellations independently of each other column-by-column into a matrix with N_{R} rows, applying a cyclic shift to each column of the matrix holding the imaginary components, and reading the real and imaginary components row-by-row. The cyclic shifts are selected for each column in accordance with a shift pattern that contains only integers that are not a multiple of N_{R}. Optimum spreading of the components over time can be achieved by configuring the shift pattern such that the average shift equals N_{R}/2. The sequence of components read from the matrix may then be divided into slices, each of which may then be transmitted through a corresponding RF channel. The present invention also provides a component interleaver for D-dimensional rotated constellations that provides an even spreading of the components of each constellation over the FEC block by setting N_{R}=D and shifting each column of the matrix holding the imaginary components by D/2 components.

## Claims

1. A method for transmitting digital data over a plurality of N_{RF} frequency channels, said method comprising the steps of:
encoding a block of data with a forward error correction code;
mapping the encoded block of data to a sequence of complex symbols;
writing the real components of the sequence of complex symbols column-by-column into a first matrix having N_{R} rows and writing the imaginary components of the sequence of complex symbols column-by-column into a second matrix having N_{R} rows;
applying a cyclic shift to each column of the second matrix such that the imaginary components of the column are rotated by a certain number, the certain number being cyclically selected for each column from a shift pattern comprising a set of integers greater than zero and less than N_{R};
obtaining a sequence of shuffled complex symbols by reading the real components of the shuffled complex symbols from the first matrix row-by-row and the imaginary components of the shuffled complex symbols from the cyclically shifted second matrix row-by-row;
dividing the sequence of shuffled complex symbols into a plurality of slices,
each slice being mapped to one of the N_{RF} frequency channels; and
transmitting the complex symbols of each slice over the corresponding frequency channel,
**characterized in that**
N_{R} is a multiple of N_{RF} greater than N_{RF}; and
the shift pattern contains only integers that are not a multiple of N_{RF}.

2. The method according to claim 1, wherein the step of mapping the encoded block of data to a sequence of complex-valued symbols is performed by
mapping the encoded block of data to a sequence of real-valued symbols, the sequence of real-valued symbols being divided into a plurality of D-dimensional vectors;
transforming each of the D-dimensional vectors by multiplying the vector with an orthogonal matrix, resulting in a plurality of constellation blocks, each constellation block consisting of D real-valued transformed symbols;
mapping the real-valued transformed symbols of the plurality of constellation blocks to the sequence of complex symbols.

3. A method for receiving digital data over a plurality of N_{RF} frequency channels, said method comprising the steps of:
receiving complex symbols of each slice of a plurality of slices over a corresponding one of the N_{RF} frequency channels;
obtaining a sequence of complex symbols by joining the received complex symbols;
writing the real components of the sequence of complex symbols row-by-row into a first matrix having N_{R} rows and writing the imaginary components of the sequence of complex symbols row-by-row into a second matrix having N_{R} rows;
applying a cyclic shift to each column of the second matrix such that the imaginary components of the column are rotated by a certain number, the certain number being cyclically selected for each column from a shift pattern comprising a set of integers greater than zero and less than N_{R};
obtaining a sequence of de-shuffled complex symbols by reading the real components of the shuffled complex symbols from the first matrix column-by-column and the imaginary components of the shuffled complex symbols from the cyclically shifted second matrix column-by-column;
demodulating an encoded block of data from the sequence of complex symbols; and
subjecting the encoded block of data to forward error correction decoding,
**characterized in that**
N_{R} is a multiple of N_{RF} greater than N_{RF}; and
the shift pattern contains only integers that are not a multiple of N_{RF}.

4. The method according to any of claims 1 to 3, wherein the shift pattern is configured such that for each first integer greater than zero and less than N_{RF} there is a second integer in the shift pattern such that a remainder of dividing the second integer by N_{RF} equals the first integer.

5. The method according to claim 4, wherein the length of the shift pattern equals N_{RF}-1.

6. The method according to any of claims 1 to 5, wherein the shift pattern is configured such that an arithmetic average of its integers equals N_{R}/2.

7. A transmitter for transmitting digital data over a plurality of N_{RF} frequency channels, said transmitter comprising:
an encoder (110) for encoding a block of data with a forward error correction code;
a symbol mapper (120) for mapping the encoded block of data to a sequence of complex symbols;
a component interleaver (140) adapted for writing the real components of the sequence of complex symbols column-by-column into a first matrix having N_{R} rows, for writing the imaginary components of the sequence of complex symbols column-by-column into a second matrix having N_{R} rows, for applying a cyclic shift to each column of the second matrix such that the imaginary components of the column are rotated by a certain number, the certain number being cyclically selected for each column from a shift pattern comprising a set of integers greater than zero and less than N_{R}, and for obtaining a sequence of shuffled complex symbols by reading the real components of the shuffled complex symbols from the first matrix row-by-row and the imaginary components of the shuffled complex symbols from the cyclically shifted second matrix row-by-row;
a scheduler (160) dividing the sequence of shuffled complex symbols into a plurality of slices, each slice being mapped to one of the N_{RF} frequency channels; and
a plurality of modulators (170-1, ..., 170-n) transmitting the complex symbols of each slice over the corresponding frequency channel,
**characterized in that**
N_{R} is a multiple of N_{RF} greater than N_{RF}; and
the shift pattern contains only integers that are not a multiple of N_{RF}.

8. The transmitter according to claim 7, further comprising
a transform unit (130) for mapping the encoded block of data to a sequence of real-valued symbols, the sequence of real-valued symbols being divided into a plurality of *D*-dimensional vectors, for transforming each of the *D*-dimensional vectors by multiplying the vector with an orthogonal matrix, resulting in a plurality of constellation blocks, each constellation block consisting of *D* real-valued transformed symbols, and for mapping the real-valued transformed symbols of the plurality of constellation blocks to the sequence of complex symbols.

9. A receiver for receiving digital data over a plurality of *N_{RF}* frequency channels, said receiver comprising:
a demodulator (270) for receiving complex symbols of each slice of a plurality of slices over a corresponding one of the N_{RF} frequency channels;
a cell extractor (255) for obtaining a sequence of complex symbols by joining the received complex symbols;
a component de-interleaver (240) adapted for writing the real components of the sequence of complex symbols row-by-row into a first matrix having N_{R} rows, for writing the imaginary components of the sequence of complex symbols row-by-row into a second matrix having N_{R} rows, for applying a cyclic shift to each column of the second matrix such that the imaginary components of the column are rotated by a certain number, the certain number being cyclically selected for each column from a shift pattern comprising a set of integers greater than zero and less than N_{R}, and for obtaining a sequence of de-shuffled complex symbols by reading the real components of the shuffled complex symbols from the first matrix column-by-column and the imaginary components of the shuffled complex symbols from the cyclically shifted second matrix column-by-column;
a constellation demapper (220) for demapping an encoded block of data from the sequence of complex symbols; and
a decoder (210) for subjecting the encoded block of data to forward error correction decoding,
**characterized in that**
N_{R} is a multiple of N_{RF} greater than N_{RF}; and
the shift pattern contains only integers that are not a multiple of N_{RF}.

10. The apparatus according to any of claims 7 to 9, wherein the shift pattern is configured such that for each first integer greater than zero and less than N_{RF} there is a second integer in the shift pattern such that a remainder of dividing the second integer by N_{RF} equals the first integer.

11. The apparatus according to claim 10, wherein the length of the shift pattern equals N_{RF}-1.

12. The apparatus according to any of claims 7 to 11, wherein the shift pattern is configured such that an arithmetic average of its integers equals N_{R}/2.

13. A method for transmitting digital data, said method comprising the steps of:
encoding a block of data with a forward error correction code;
mapping the encoded block of data to a sequence of real-valued symbols, the sequence of real-valued symbols being divided into a plurality of *D-*dimensional vectors;
transforming each of the *D*-dimensional vectors by multiplying the vector with an orthogonal matrix, resulting in a plurality of constellation blocks, each constellation block consisting of *D* real-valued transformed symbols;
mapping the real-valued transformed symbols of the plurality of constellation blocks to a sequence of complex symbols;
writing the real components of the sequence of complex symbols column-by-column into a first matrix having N_{R} rows and writing the imaginary components of the sequence of complex symbols column-by-column into a second matrix having N_{R} rows;
applying a cyclic shift to each column of the second matrix;
obtaining a sequence of shuffled complex symbols by reading the real components of the shuffled complex symbols from the first matrix row-by-row and the imaginary components of the shuffled complex symbols from the cyclically shifted second matrix row-by-row; and
transmitting the shuffled complex symbols,
**characterized in that**
the number of rows N_{R} of the first and the second matrix equals D, and
the cyclic shift is performed such that the imaginary components of each column are rotated by D/2 components.

14. A method for receiving digital data, said method comprising the steps of:
receiving a sequence of complex symbols;
writing the real components of the sequence of complex symbols row-by-row into a first matrix having N_{R} rows and writing the imaginary components of the sequence of complex symbols row-by-row into a second matrix having N_{R} rows;
applying a cyclic shift to each column of the second matrix;
obtaining a sequence of de-shuffled complex symbols by reading the real components of the shuffled complex symbols from the first matrix column-by-column and the imaginary components of the shuffled complex symbols from the cyclically shifted second matrix column-by-column;
demapping (255, 230) a plurality of constellation blocks from the sequence of complex symbols, each constellation block consisting of *D* real-valued transformed symbols;
demodulating an encoded block of data from the plurality of constellation blocks; and
subjecting the encoded block of data to forward error correction decoding,
**characterized in that**
the number of rows N_{R} of the first and the second matrix equals D, and
the cyclic shift is performed such that the imaginary components of each column are rotated by D/2 components.

15. A transmitter for transmitting digital data, said transmitter comprising:
an encoder (110) for encoding a block of data with a forward error correction code;
a symbol mapper (120) for mapping the encoded block of data to a sequence of real-valued symbols, the sequence of real-valued symbols being divided into a plurality of *D*-dimensional vectors;
a transform unit (130) for transforming each of the *D*-dimensional vectors by multiplying the vector with an orthogonal matrix, resulting in a plurality of constellation blocks, each constellation block consisting of *D* real-valued transformed symbols, and for mapping the real-valued transformed symbols of the plurality of constellation blocks to a sequence of complex symbols;
a component interleaver (140) adapted for writing the real components of the sequence of complex symbols column-by-column into a first matrix having N_{R} rows and writing the imaginary components of the sequence of complex symbols column-by-column into a second matrix having N_{R} rows, for applying a cyclic shift to each column of the second matrix, and for obtaining a sequence of shuffled complex symbols by reading the real components of the shuffled complex symbols from the first matrix row-by-row and the imaginary components of the shuffled complex symbols from the cyclically shifted second matrix row-by-row; and
a modulator (170-1) for transmitting the shuffled complex symbols,
**characterized in that**
the number of rows N_{R} of the first and the second matrix equals D, and
the cyclic shift is performed such that the imaginary components of each column are rotated by D/2 components.

16. A receiver for receiving digital data, said receiver comprising:
a demodulator (270) for receiving a sequence of complex symbols;
a component de-interleaver (240) adapted for writing the real components of the sequence of complex symbols row-by-row into a first matrix having N_{R} rows and writing the imaginary components of the sequence of complex symbols row-by-row into a second matrix having N_{R} rows, for applying a cyclic shift to each column of the second matrix, and for obtaining a sequence of de-shuffled complex symbols by reading the real components of the shuffled complex symbols from the first matrix column-by-column and the imaginary components of the shuffled complex symbols from the cyclically shifted second matrix column-by-column;
a constellation demapper (220) for demapping a plurality of constellation blocks from the sequence of complex symbols, each constellation block consisting of *D* real-valued transformed symbols and for demodulating an encoded block of data from the plurality of constellation blocks; and
a decoder (210) for subjecting the encoded block of data to forward error correction decoding,
**characterized in that**
the number of rows N_{R} of the first and the second matrix equals D, and
the cyclic shift is performed such that the imaginary components of each column are rotated by D/2 components.
